# EUROPEAN PATENT SPECIFICATION

(11) **EP 3 522 207 B1**
(45) Date of publication and mention of the grant of the patent: **16.09.2020**
(21) Application number: 16917656.7
(22) Date of filing: 28.09.2016
(51) Int. Cl.: H01L 21/67, H01L 21/677, H01L 21/683, H05K 13/04, H05K 13/08

(54) **WAFER FEEDING APPARATUS AND COMPONENT MOUNTING APPARATUS**
WAFERZUFÜHRVORRICHTUNG UND KOMPONENTENMONTAGEVORRICHTUNG
APPAREIL D'ALIMENTATION DE TRANCHE ET APPAREIL DE MONTAGE DE COMPOSANT

(43) Date of publication of application: 07.08.2019
(73) Proprietor: Fuji Corporation, Chiryu-shi, Aichi 472-8686 (JP)
(72) Inventor: KAWAGUCHI, Koji, Chiryu Aichi (JP); ICHIKAWA, Shigeto, Chiryu Aichi (JP)
(74) Representative: Grünecker Patent- und Rechtsanwälte PartG mbB
(86) International application number: PCT/JP2016/078585
(87) International publication number: WO 2018/061103

(56) References cited:
- WO-A1-2015/140888
- JP-A- H0 969 553
- JP-A- H10 150 093
- JP-A- 2004 273 910
- JP-A- 2006 185 941
- JP-A- 2008 141 068
- JP-A- 2008 300 437
- JP-A- 2012 146 762
- JP-A- 2013 247 314
- JP-U- 3 205 044
- JP-U- 3 205 044
- US-A1- 2015 282 398

## Description

### Technical Field

The present invention relates to a component mounting apparatus.

### Background Art

Conventionally, there has been proposed a component mounting system having a bonding head configured to pick up a pellet (i.e., a die) adhered to an adhesion sheet while pressing against the pellet with a suction nozzle from the pellet side and then bond the pellet to a board; and a pellet push-up unit for detaching the pellet from the adhesive sheet by pushing up the pellet from the back surface of the adhesive sheet by using a push-up pin (for example, refer to document JP2004-273910-A ). The pellet push-up unit includes a pin support configured to support a push-up pin and lift the push-up pin with the rotation of a cam, a motor for driving the cam, and a load measuring device provided on the pin support, wherein the load measuring device measures the push-up load acting on the pellet when the pellet is being pushed up by the push-up pin. During the pickup operation on the pellet by the suction nozzle, the bonding head adjusts the push-up load acting on the pellet by feedback control based on the measured value of the push-up load.

### Patent Literature

Prior art is disclosed in the documents JP2004-273910-A, JP3205044-U, WO2015/140888-A1, JP2012-146762-A and JPH10150093-A.

### Summary of Invention

### Technical Problem

However, in the system disclosed in JP2004-273910-A , since the cam is rotated by the motor to lift the push-up pin while continuously measuring the push-up load, it takes time to push up the pellet (i.e., the die).

It is a main object of the present invention to peel the component from the sheet at a high speed and with high accuracy.

### Solution to Problem

The present invention according to claims 1 and 2 comprises the following unit to achieve the above-mentioned main object.

The present invention comprises a wafer supply apparatus for use in a component mounting apparatus for mounting a component on a target object by picking up a component with a nozzle from a sheet to which a wafer, being divided into multiple components, is adhered, the wafer supply apparatus comprising: a push-up section configured to push up, from the back side of the sheet, a component to be picked up by the nozzle; a first push-up section lifting and lowering device configured to lift and lower a lifting and lowering member; and a second push-up section lifting and lowering device configured to move up and down with the lifting and lowering member by the first push-up lifting and lowering device and to lift and lower the push-up section with respect to the lifting and lowering member.

The wafer supply apparatus of the present invention includes:a push-up section configured to push up, from the back side of the sheet, a component to be picked up by the nozzle, a first lifting and lowering device configured to lift and lower the lifting and lowering member, and a second push-up section lifting and lowering device configured to move up and down with the lifting and lowering member by the first push-up lifting and lowering device and to lift and lower the push-up section with respect to the lifting and lowering member. As a result, the wafer supply apparatus can perform the push-up operation at high speed with the first push-up section lifting and lowering device, and can perform the push-up operation with high accuracy with the second push-up section lifting and lowering device. As a result, the component can be peeled off from the sheet at high speed and with high accuracy.

The wafer supply apparatus of the present invention may include: a load measuring section configured to measure a load acting on the push-up section; and a control section configured to control the first push-up section lifting and lowering device and the second push-up section lifting and lowering device so that the push-up section is pushed up based on the load amount measured by the load measuring section when a component is being picked up by the nozzle.

In the wafer supply apparatus of the present invention, the control section may be configured to control the first push-up lifting and lowering device so that the push-up section is pushed up to a predetermined push-up position, and to control the second push-up lifting and lowering device so that the load amount measured by the load measuring section is maintained within a predetermined push-up load range while a component is being pushed up in the push-up section. In this manner, the wafer supply apparatus can apply an appropriate load to peel the component from the sheet without damaging the component.

Further, in the wafer supply apparatus of the present invention, the control section may be configured to control the second push-up section lifting and lowering device so that the load amount measured by the load measuring section is maintained at a target load while a component is being pushed up in the push-up section, and to change the target load according to the push-up amount or the push-up position of the push-up section. In this way, since the push-up load can be changed according to the peeling progress of the component, it is possible to more reliably suppress damage when pushing up the component.

The first component mounting apparatus of the present invention is a component mounting apparatus for mounting a component on a target object by picking up the component with a nozzle from a sheet on which a wafer, being divided into multiple components, is adhered, comprising: a head;
a nozzle; a nozzle lifting and lowering device configured to lift and lower the nozzle with respect to the head; a push-up section configured to push up, from the back side of the sheet, a component to be picked up by the nozzle; a first push-up section lifting and lowering device configured to lift and lower a lifting and lowering member; a second push-up section lifting and lowering device configured to move up and down with the lifting and lowering member by the action of the first push-up section lifting and lowering device, and to lift and lower the push-up section with respect to the lifting and lowering member; and a control section configured to control the nozzle lifting and lowering device and the first push-up section lifting and lowering device so that the nozzle is lowered to a predetermined nozzle position and the push-up section is pushed up to a predetermined push-up position, and to control the second push-up section lifting device so that the load amount measured by the load measuring section is maintained within a predetermined push-up load range while the component is being pushed up in the push-up section.

The first component mounting apparatus of the present invention includes a head, a nozzle, and a nozzle lifting and lowering device for lifting and lowering the nozzle with respect to the head. Further, the first component mounting apparatus includes: a push-up section configured to push up, from the back side of the sheet, a component to be picked up by the nozzle; a first push-up section lifting and lowering device configured to lift and lower the lifting and lowering member; a second push-up section lifting and lowering device configured to move up and down together with the lifting and lowering member by the action of the first push-up section lifting and lowering device, and to lift and lower the push-up section with respect to the lifting and lowering member; and a load measuring section configured to measure a load amount acting on the push-up section. The first component mounting apparatus is configured to control the nozzle lifting and lowering device and the first push-up section lifting and lowering device so that the nozzle is lowered to a predetermined nozzle position and the push-up section is pushed up to a predetermined push-up position, and the first component mounting apparatus is configured to control the second push-up section lifting and lowering device so that the load amount measured by the load measuring section is maintained within a predetermined push-up load range while the component is being pushed up in the push-up section. Accordingly, the first component mounting apparatus can perform the push-up operation at a high speed with the first push-up section lifting and lowering device, and can perform the push-up operation with high accuracy with the second push-up section lifting and lowering device. As a result, the first component mounting apparatus can peel the component from the sheet at a high speed and with high accuracy.

A second component mounting apparatus according to the present invention is a component mounting apparatus for mounting a component on a target object by picking up the component with a nozzle from a sheet on which a wafer, being divided into multiple components, is adhered, comprising: a head; a nozzle; a first nozzle lifting and lowering device configured to lift and lower a lifting and lowering member with respect to the head; a second nozzle lifting and lowering device configured to lift and lower the nozzle with respect to the lifting and lowering member and lifting and lowering the nozzle with respect to the lifting and lowering member; a push-up section configured to push up, from the back side of the sheet, a component to be picked up by the nozzle; a push-up section lifting and lowering device configured to lift and lower the push-up section; a load measuring section configured to measure the load amount acting on the nozzle; and a control section configured to control the first nozzle lifting and lowering device and the push-up section lifting and lowering device so that the nozzle is lowered to a predetermined nozzle position and the push-up section is pushed up to a predetermined push-up position, and to control the second nozzle lifting and lowering device so that the load amount measured by the load measuring section is maintained within a predetermined push-up load range while the nozzle is in contact with the component and the component is being pushed up in the push-up section.

The second component mounting apparatus of the present invention includes: a head, a nozzle, a first nozzle lifting and lowering device configured to lift and lower the lifting and lowering member with respect to the head, and a second nozzle lifting and lowering device configured to move up and down with the lifting and lowering member and is to lift and lower the nozzle with respect to the lifting member. The second component mounting apparatus includes: a push-up section configured to push up, from the back side of the sheet, a component to be picked up by the nozzle, a push-up section lifting and lowering device configured to lift and lower the push-up section, and a load measuring section configured to measure the load amount acting on the nozzle. The second component mounting apparatus is configured to control the first nozzle lifting and lowering device and the push-up section lifting and lowering device so that the nozzle is lowered to a predetermined nozzle position and the push-up section is pushed up to a predetermined push-up position, and the second component mounting apparatus is configured to control the second nozzle lifting and lowering device so that the load amount measured by the load measuring section is maintained within a predetermined push-up load range while the nozzle is in contact with the component and the component is being pushed up in the push-up section. In this way, the second component mounting apparatus can operate the nozzle at a high speed with the first nozzle lifting and lowering device, and can operate the nozzle at high accuracy with the second nozzle lifting and lowering device. As a result, the second component mounting apparatus can remove the component from the sheet and pick up the component with the nozzle at a high speed and with high accuracy.

In the second component mounting apparatus of the present invention, the control section may control the first nozzle lifting and lowering device so that the nozzle is lowered to the predetermined nozzle position, the control section may control the second nozzle lifting and lowering device so that the nozzle comes into contact with the component and the load amount measured by the load measuring section falls within a predetermined contact load range, the control section may control the push-up section lifting and lowering device so that the component is pushed up by the push-up section, and the control section may control the second nozzle lifting and lowering device so that the load amount measured by the load measuring section is maintained within a predetermined push-up load range while the nozzle is in contact with the component and the component is being pushed up by the push-up section. In this way, it is possible to suppress an excessive load from acting on the component when the nozzle comes into contact with the component, thereby more reliably suppressing damage to the component.

### Brief Description of Drawings

Fig. 1 is a diagram showing an outline of a configuration of component mounting system 10.
Fig. 2 is a top view showing an outline of a configuration of die peeling device 50.
Fig. 3 is a side view showing an outline of the configuration of die peeling device 50.
Fig. 4 is a diagram showing an outline of the configuration of lifting and lowering device 60.
Fig. 5 is a block diagram showing electrical connections in component mounting system 10.
Fig. 6 is a flowchart showing an example of pickup processing.
Fig. 7 is a flowchart showing an example of die peeling processing.
Fig. 8 is a diagram showing the relationship between target load F* and the push-up amount of push-up pin 71.
Fig. 9 is a view showing a state in which die D adhered to die sheet 43 is picked up by suction nozzle 24 while being peeled off from die sheet 43.
Fig. 10 is a diagram showing the outline of a configuration of mounting head 122 according to an alternative embodiment.
Fig. 11 is a block diagram showing electrical connections of component mounting system 110 using mounting head 122 according to the alternative embodiment.
Fig. 12 is a flowchart showing pickup processing according to the alternative embodiment.
Fig. 13 is a flowchart showing die peeling processing according to the alternative embodiment.

### Description of Embodiments

Next, embodiments of the present invention will be described with reference to the drawings.

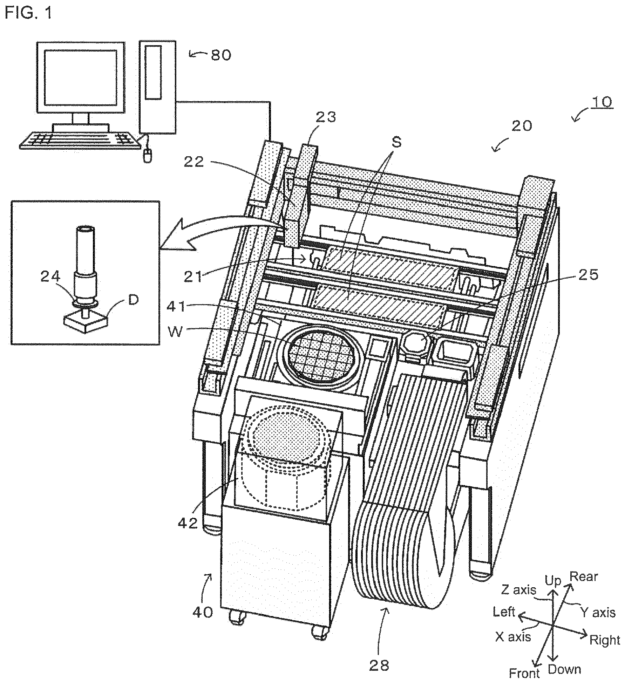

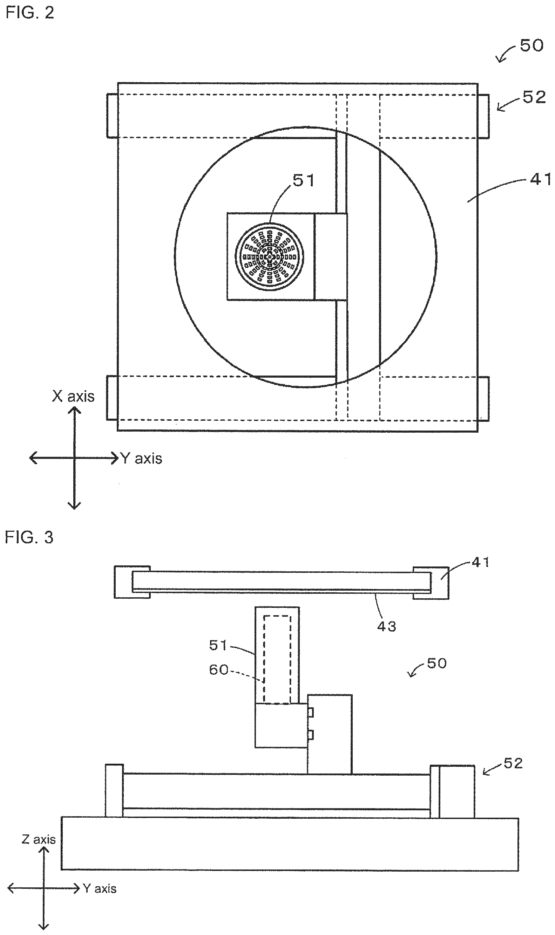

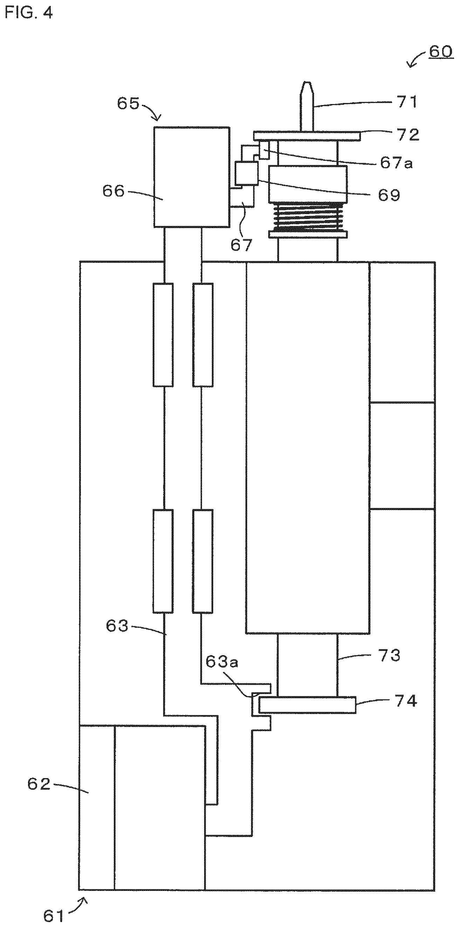

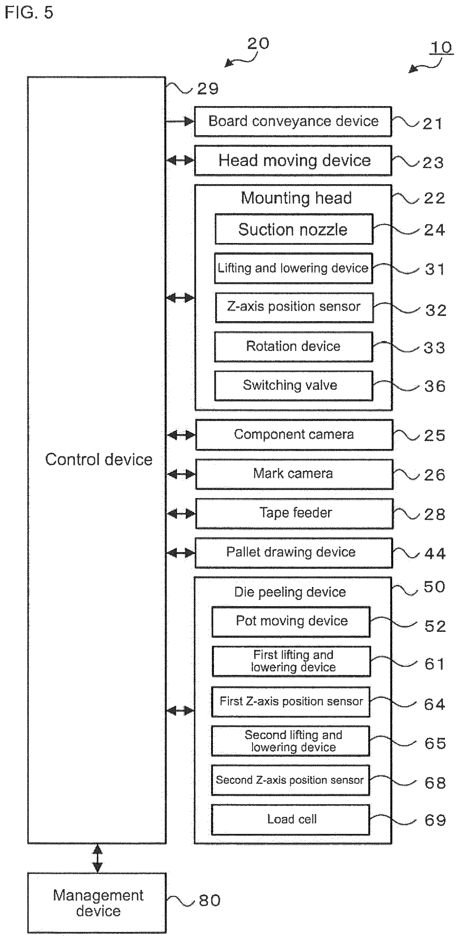

Fig. 1 is a diagram schematically showing a configuration of component mounting system 10, Fig. 2 is a top view schematically showing a configuration of die peeling device 50, Fig. 3 is a side view schematically showing the configuration of die peeling device 50, Fig. 4 is a diagram schematically showing a configuration of lifting and lowering device 60, and Fig. 5 is a block diagram showing electrical connections of component mounting system 10. In Fig. 1, the left-right direction is the X-axis direction, the front-rear direction is the Y-axis direction, and the up-down direction is the Z-axis direction.

As shown in Fig. 1, component mounting system 10 is a system for mounting components such as die D, obtained by dividing wafer W, on an object (such as board S or other components), and also provided are component mounting apparatus 20 and management computer (PC) 80. In component mounting system 10, multiple component mounting apparatus 20 for mounting components on board S are arranged from upstream to downstream. In Fig. 1, only one component mounting apparatus 20 is shown for convenience of the description. Component mounting system 10 may include a solder printing machine, an inspection machine, a reflow oven, and the like on the same mounting line as component mounting apparatus 20.

Component mounting apparatus 20 includes board conveyance device 21, mounting head 22, head moving device 23, suction nozzle 24, component camera 25, mark camera 26, tape supply device 28, wafer supply apparatus 40, and control device 29. Board conveyance device 21 loads and transfers board S, fixes board S at the mounting position, and unloads it. Board conveyance device 21 has a pair of conveyor belts that are provided with a space between the front and rear sides in Fig. 1 and span board conveyance device 21 in the left-right direction. Board S is conveyed by the conveyor belts.

Mounting head 22 is a head for picking up die D supplied from wafer supply apparatus 40 and components supplied from tape supply device 28 and mounting die D and the components on board S fixed to board conveyance device 21, and mounting head 22 is movable in the XY-axis direction by head moving device 23. Head moving device 23 includes a slider that is guided by guide rails and moves in the XY-axis direction, a motor for driving the slider, and a position sensor for detecting the position of the slider in the XY-axis direction. One or more nozzle holders are attached to mounting head 22, and suction nozzle 24 is detachably attached to the lower face of the nozzle holder. Suction nozzle 24 has a suction port communicating with a negative pressure source and a positive pressure source through switching valve 36, and by driving switching valve 36, it is possible to apply negative pressure to the suction port to pick up a component or apply positive pressure to the suction port to release the component from the suction. Mounting head 22 has built-in lifting and lowering device 31, and the height of suction nozzle 24 can be adjusted along the Z-axis by lifting and lowering device 31. Lifting and lowering device 31 includes a slider that moves in the Z-axis direction, a motor for driving the slider, and Z-axis position sensor 32 for detecting the position of the slider in the Z-axis direction. Further, mounting head 22 includes rotation device 33, and the angle of the component picked up by suction nozzle 24 can be adjusted by lifting and lowering device 31. Rotation device 33 includes a motor for rotating the nozzle holder holding suction nozzle 24 and a rotational position sensor for detecting the rotational position of the motor.

Component camera 25 is provided between board conveyance device 21 and tape supply device 28. When suction nozzle 24, which has picked up a component, passes over component camera 25, component camera 25 captures an image, from below, of the component picked up by suction nozzle 24 and outputs the image to control device 29.

Mark camera 26 is provided on head moving device 23 so as to be movable in the XY-axis direction. Mark camera 26 captures an image, from above, of a positioning reference mark disposed on board S in order to confirm the position of board S when board S is conveyed and outputs the image to control device 29. Mark camera 26 captures an image of wafer W including die D to be picked up by mounting head 22 from above, and outputs the image to control device 29.

Tape supply device 28 includes a reel on which tape containing components is wound, and the tape is pulled out from the reel to supply the components to component mounting apparatus 20.

Wafer supply apparatus 40 is a device for supplying die D, obtained by dividing wafer W, to the pickup position of mounting head 22 and includes wafer pallet 41, magazine 42, and die peeling device 50. Wafer pallet 41 is fixed in a state in which die sheet 43 to which wafer W is adhered is stretched. Multiple wafer pallets 41 are accommodated in magazine 42, and are pulled out from magazine 42 by pallet drawing device 44 when mounting head 22 picks up die D.

As shown in FIGS. 2 and 3, die peeling device 50 includes pot 51, pot moving device 52, push-up pin 71 (see Fig. 4), and lifting and lowering device 60. Pot 51 is disposed below wafer pallet 41 drawn out by pallet drawing device 44, and can be moved in the XY-axis direction by pot moving device 52. Pot moving device 52 includes a slider that moves in the XY-axis direction while being guided by guide rails, a motor for driving the slider, and a position sensor for detecting the position of the slider in the XY-axis direction. Push-up pin 71 is disposed inside pot 51 and pushes up die D to be picked up out of separated dies D of wafer W adhered to die sheet 43 from the back side of die sheet 43. The lower end of push-up pin 71 is supported by pin support 73. Push-up pin 71 is attached to pin support 73 so as to be movable in the up-down direction (Z-axis direction). A compression coil spring (not shown) is built into pin support 73, and push-up pin 71 is biased downward with respect to pin support 73 by the biasing force of the compression coil spring. Multiple types of push-up pins 71 having different thicknesses, different quantities of push-up pins 71, and the like can be provided according to the size of die D. Die peeling device 50 includes multiple pots 51 having push-up pins 71 of different types, and any one of pots 51 can be selected according to the size of die D to push up die D. With a suction port being provided on the upper surface of pot 51, die peeling device 50 can selectively push up only die D, which is the target to be picked up, and peel off die D from die sheet 43 by pushing up push-up pin 71 in a state in which die sheet 43 is supported by suction force on the upper face of pot 51.

As shown in Fig. 4, lifting and lowering device 60 includes first lifting and lowering device 61, second lifting and lowering device 65, and load cell 69. Lifting and lowering device 60 is configured to lift and lower pot 51 together with push-up pin 71, and when the upper surface of pot 51 comes close to a position substantially in contact with die sheet 43, lifting and lowering of pot 51 stops by a stopper mechanism (not shown), and thereafter, push-up pin 71 protrudes from the upper surface of pot 51 to push up die D from the back side of die sheet 43.

First lifting and lowering device 61 includes first linear motor 62, first Z-axis slider 63 which can be lifted and lowered in the Z-axis direction by the driving force of first linear motor 62, and first Z-axis position sensor 64 which detects the position of first Z-axis slider 63 in the Z-axis direction. First Z-axis slider 63 is formed with first engaging section 63a that can engage with horizontal section 74 provided on pin support 73 which supports push-up pin 71. As a result, push-up pin 71 can be moved up and down together with the up and down movement of first Z-axis slider 63.

Second lifting and lowering device 65 includes second linear motor 66 attached to first Z-axis slider 63 of first lifting and lowering device 61, second Z-axis slider 67 which can be lifted and lowered in the Z-axis direction by the driving force of second linear motor 66, and second Z-axis position sensor 68 which detects the position of second Z-axis slider 67 in the Z-axis direction. Second Z-axis slider 67 is formed with second engaging section 67a which can engage with the lower face of flange section 72 extending in the radial direction in the lower section of push-up pin 71. As a result, push-up pin 71 can be moved up and down together with the up and down movement of second Z-axis slider 67. In the present embodiment, the stroke distance of second Z-axis slider 67 by second lifting and lowering device 65 is shorter than the stroke distance of first Z-axis slider 63 by first lifting and lowering device 61. After coarsely adjusting the Z-axis position of push-up pin 71 with first lifting and lowering device 61, lifting and lowering device 60 can finely adjust the Z-axis position of push-up pin 71 with second lifting and lowering device 65. Second Z-axis slider 67 is provided with load cell 69 for detecting load F acting on push-up pin 71 when push-up pin 71 pushes up die D.

Control device 29 is configured as a microprocessor centered around a CPU, and includes ROM, RAM, an input/output port, and the like. As shown in Fig. 5, control device 29 receives signals from mounting head 22 (i.e., Z position sensor 32 or rotational position sensor), head moving device 23 (i.e., position sensor), component camera 25, mark camera 26, tape supply device 28, pallet drawing device 44, die peeling device 50 (i.e., first Z-axis position sensor 64, second Z-axis position sensor 68, and load cell 69) via the input port. Further, control device 29 outputs signals to board conveyance device 21, mounting head 22 (i.e., lifting and lowering device 31, rotation device 33, switching valve 36), component camera 25, mark camera 26, tape supply device 28, pallet drawing device 64, and die peeling device 50 (i.e., pot moving device 52, first lifting device 61, and second lifting device 65) via the output port.

Management PC 80 is communicably connected to control device 29 of component mounting apparatus 20, and manages job information and the like. The job information includes, for example, information such as the mounting order of components, the type and size of components to be mounted, the device to be used, the size of board S, and the number of boards to be produced.

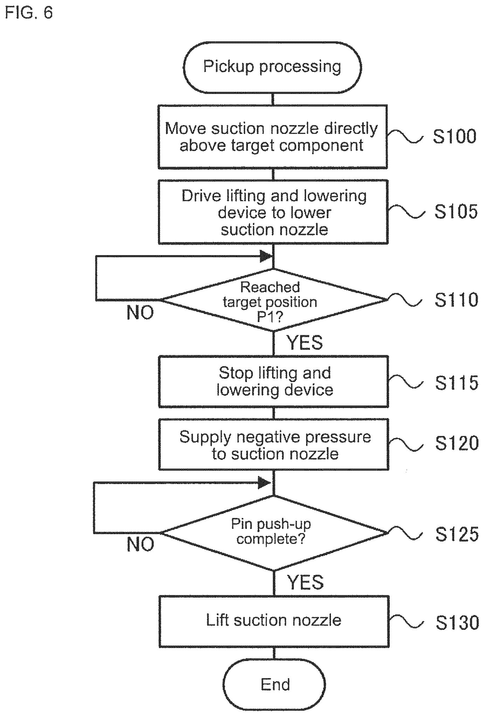

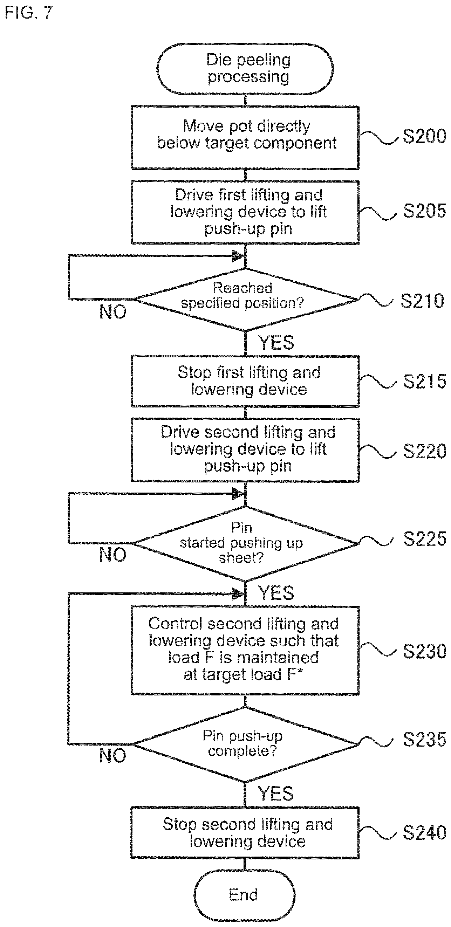

Next, the operation of component mounting system 10 of the present embodiment configured as described above, in particular, the operation of picking up die D adhered to die sheet 43 while peeling off die sheet 43 will be described. Fig. 6 is a flowchart showing an example of pickup processing, and Fig. 7 is a flowchart showing an example of the die peeling processing. In the present embodiment, the pickup processing and the die peeling processing are executed in parallel by control device 29 when a production command including job information is received from management PC 80. In the present embodiment, the pickup processing and the die peeling processing are executed by the same control device 29, but may be executed by different control devices capable of exchanging signals with each other.

In the pickup processing, first, control device 29 drives and controls head moving device 23 so that suction nozzle 24 is moved to a position directly above die D (i.e., the target die) to be picked up (step S100). Next, control device 29 drives and controls lifting and lowering device 31 so that suction nozzle 24 is lowered (step S105) and then determines whether the position of suction nozzle 24 in the Z-axis direction has reached target position P1 (step S110). Here, target position P1 is a position at which suction nozzle 24 picks up die D, and is determined to be a position corresponding to the position of die D when die D is peeled from die sheet 43 by die peeling device 50. When it is determined that the position of suction nozzle 24 has not reached target position P1, control device 29 continues to lower suction nozzle 24 with lifting and lowering device 31, and when it is determined that the position of suction nozzle 24 has reached target position P1 (step S115), control device 29 stops driving lifting and lowering device 31, and drives switching valve 36 to supply negative pressure to the suction port of suction nozzle 24 (step S120). Then, control device 29 waits until the pushing up of the target die by push-up pin 71 is completed in die peeling device 50 (step S125), then drives and controls lifting and lowering device 31 so that suction nozzle 24 (step S130) is lifted, then ends the pickup processing. The process of step S125 is performed based on the determination result of step S235 of the die peeling processing.

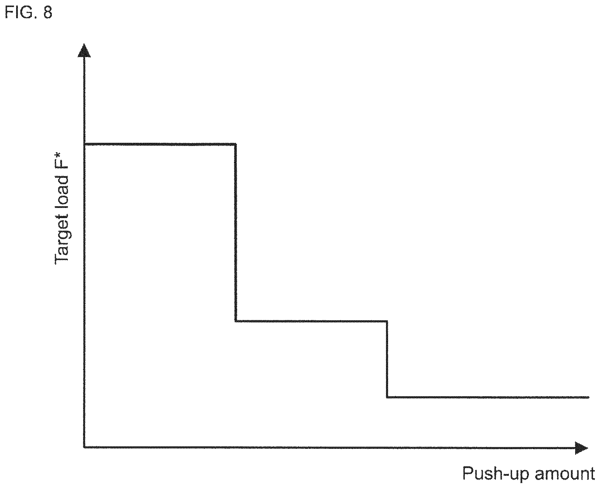

On the other hand, in the die peeling processing, control device 29 first drives and controls pot moving device 52 so that pot 51 is moved to a location directly under target die in step S200. Next, in step S205, control device 29 drives and controls first lifting and lowering device 61 so that push-up pin 71 is lifted at a high speed. Control device 29 determines whether the position of push-up pin 71 in the Z-axis direction, being specified based on signals from first Z-axis position sensor 64 and second Z-axis position sensor 68, has reached a specified position (step S210). Here, the specified position is defined as a position ahead of the position where push-up pin 71 contacts die sheet 43 by a predetermined distance. When it is determined that the position of push-up pin 71 has not reached the specified position, control device 29 continues to lift push-up pin 71 with first lifting and lowering device 61, and when it is determined that the position of push-up pin 71 has reached the specified position, the driving of first lifting and lowering device 61 is stopped (step S215), and second lifting and lowering device 65 is driven and controlled so that push-up pin 71 is further lifted but at a low speed (step S220). Next, in step S225, control device 29 determines whether push-up pin 71 has started to push up target die. This processing can be performed, for example, by determining whether load F acting on push-up pin 71 detected by load cell 69 exceeds a predetermined load. When it is determined that the target die is not being pushed up by push-up pin 71, control device 29 continues lifting push-up pin 71, and when it is determined that lifting of the target die by pusher pin 71 has started, second lifting and lowering device 65 is driven and controlled by feedback control (step S230) so that load F acting on push-up pin 71 is maintained at target load F*. Here, in the present embodiment, as illustrated in Fig. 8, target load F* is decreased in steps as the push-up amount of the target die by push-up pin 71 increases (i.e., the push-up position increases). Since the entire lower surface of die D is adhered to die sheet 43, it is necessary to push up push-up pin 71 with a relatively high initial load in order to push up die D from the back side of die sheet 43 to peel off from die sheet 43. When die D is pushed up by push-up pin 71, die D is initially peeled off slowly from the outer peripheral edge. Since die D has a smaller area adhered to die sheet 43 as the peeling progresses, the peeling speed increases and the necessary load decreases. By decreasing target load F* as the push-up amount of push-up pin 71 increases, control device 29 can apply a suitable push-up load corresponding to the progress of the peeling of die D so as to peel die D from die sheet 43 without damaging die D. Here, in order to improve the controllability, control device 29 may stop second lifting and lowering device 65 and temporarily stop the lifting of push-up pin 71 when changing target load F*. Control device 29 determines whether pushing up of push-up pin 71 has been completed (step S235). This process determines whether the upper surface of the target die has come into contact with the tip of suction nozzle 24, which is performed by determining whether the position of push-up pin 71 in the Z-axis direction, being specified based on the signals from first Z-axis position sensor 64 and second Z-axis position sensor 68, has reached target position P2 corresponding to target position P1 of suction nozzle 24. When it is determined that the pushing up of push-up pin 71 is completed, control device 29 stops the driving of second lifting and lowering device 65 (step S240), then ends the die peeling processing.

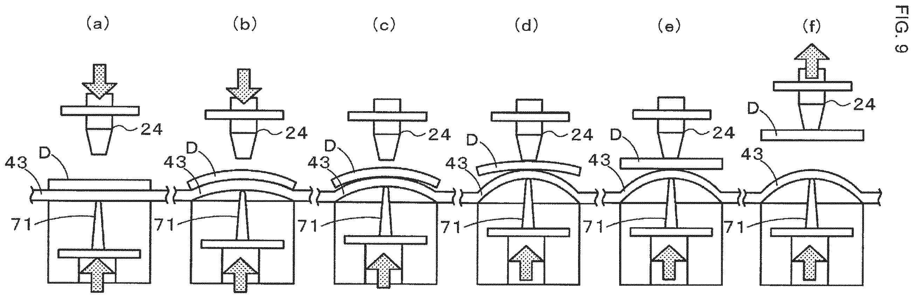

Fig. 9 is a view showing a state in which die D adhered to die sheet 43 is picked up by suction nozzle 24 while being peeled off from die sheet 43. Control device 29 drives and controls lifting and lowering device 31 so that suction nozzle 24 is lowered to the target position (i.e., the pick-up position) from directly above die D to be picked up, and control device 29 drives and controls lifting and lowering device 60 and lifts push-up pin 71 so that suction nozzle 24 pushes up die D to be picked up (see FIGS. 9(a)-(c)). Specifically, until push-up pin 71 comes into contact with die sheet 43, control device 29 lifts push-up pin 71 at a high speed with first lifting and lowering device 61, and when push-up pin 71 comes into contact with die sheet 43, second lifting device 65 lifts push-up pin 71 at a low speed. Then, when the pushing up of die D is started by push-up pin 71, control device 29 drives and controls second lifting device 65 using feedback control so that load F acting on push-up pin 71 becomes target load F*. This allows die D to be suitably peeled away from die sheet 43 without damaging die D (see FIGS. 9(d), (e)). When the pushing up of die D by push-up pin 71 is completed, control device 29 lifts suction nozzle 24 to pick up die D peeled off from die sheet 43 (see Fig. 9(f)).

Here, the correspondence between the main elements of the present embodiment and the main elements of the invention described in the disclosure section of the invention will be described. Push-up pin 71 corresponds to a "push-up section", first lifting and lowering device 61 corresponds to a "first push-up section lifting and lowering device", and second lifting and lowering device 65 corresponds to a "second push-up section lifting and lowering device". Load cell 69 corresponds to a "load measuring section" and control device 29 corresponds to a "control section". Mounting head 23 corresponds to a "head", suction nozzle 24 corresponds to a "nozzle", and lifting and lowering device 31 corresponds to a "nozzle lifting and lowering device".

Wafer supply apparatus 40 of the present embodiment described above includes die peeling device 50 in which die D to be picked up is peeled from die sheet 43 by pushing up die D from the back side of die sheet 43 with push-up pin 71 when mounting head 22 picks up die D from die sheet 43 to which wafer W is adhered. Die peeling device 50 is configured with push-up pin 71, first lifting and lowering device 61 for lifting and lowering first Z-axis slider 63, and second lifting and lowering device 65, which is lifted and lowered together with first Z-axis slider 63, and lifts and lowers push-up pin 71 with respect to first Z-axis slider 63. Thus, wafer supply apparatus 40 (i.e., die peeling device 50) can lift push-up pin 71 at a high speed with first lifting and lowering device 61, and can thereafter lift push-up pin 71 at a low speed with second lifting and lowering device 65. As a result, it is possible to prevent excessive stress from acting on die D when die D is pushed up by push-up pin 71 and quickly execute peeling of die D without damaging die D.

Further, wafer supply apparatus 40 of the present embodiment drives and controls second lifting and lowering device 65 with feedback control so that load F acting on push-up pin 71 is maintained at target load F* when second lifting and lowering device 65 is driven to push up the target die by push-up pin 71. Thus, excessive stress is prevented from acting on the target die by the pushing up of push-up pin 71, and damage to the target die is effectively suppressed.

The present invention is not limited in any way to the above-mentioned embodiments, and it is needless to say that the present invention can be implemented in various forms as long as they fall within the technical scope of the present invention as defined by the appended claims.

For example, in the embodiment described above, in the pickup process of Fig. 6, after suction nozzle 24 is lowered to target position P1, control device 29 causes suction nozzle 24 to stand by at target position P1 until die D is pushed up by push-up pin 71. However, in the pickup process, control device 29 may lower suction nozzle 24 to come into contact with die D before die D is pushed up and may lift suction nozzle 24 with push-up pin 71 pushing up die D. In this case, in the die peeling processing, control device 29 may cause push-up pin 71 to follow the ascent of suction nozzle 24 based on load F acting on push-up pin 71 so that load F becomes target load F*.

Further, in the embodiment described above, target load F* at the time of pushing up die D by push-up pin 71 is changed in accordance with the pushing up amount (i.e., the pushing up position) of push-up pin 71, but a constant load may be set as target load F* while pushing up die D with push-up pin 71.

In the embodiment described above, lifting and lowering device 60 is provided with load cell 69 for measuring load F acting on push-up pin 71, but the load acting on push-up pin 71 may be measured by detecting or estimating the load current of second linear motor 66.

In the embodiment described above, first linear motor 62 is used as the actuator of first lifting and lowering device 61, but a voice coil motor, a ball screw mechanism, or the like may be used. Further, although second linear motor 66 is used as the actuator of second lifting and lowering device 65, a voice coil motor or the like may be used.

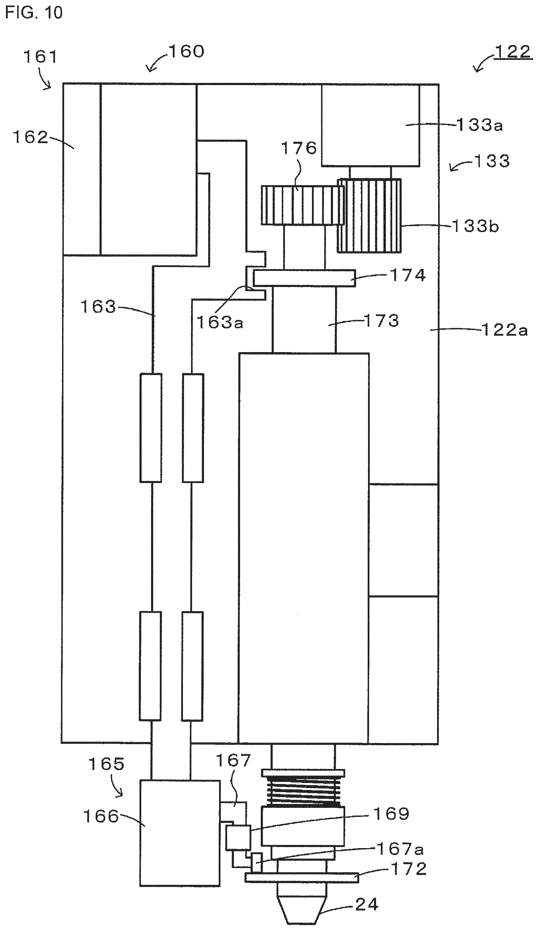

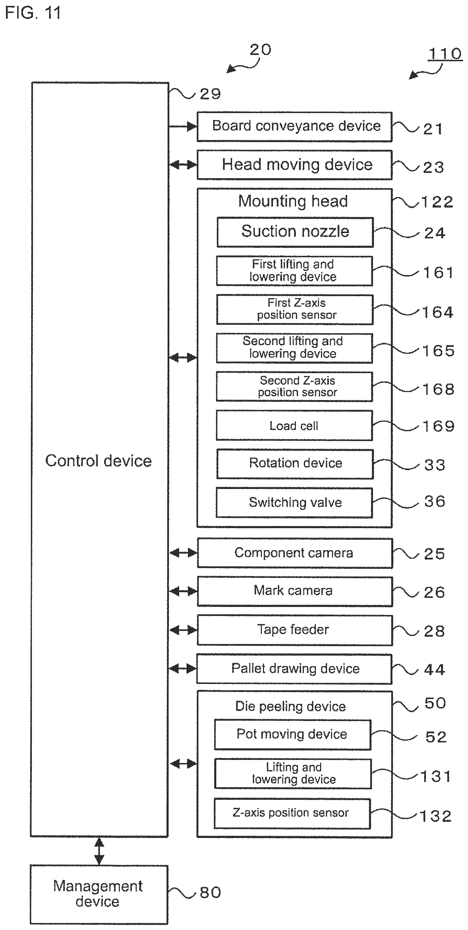

In the embodiment described above, lifting and lowering device 60 of die peeling device 50 is configured with first lifting and lowering device 61 and second lifting and lowering device 65, but the lifting and lowering device of the mounting head may be configured by a first lifting and lowering device and a second lifting and lowering device. Fig. 10 is a diagram showing an outline of a configuration of mounting head 122 in a modified example, and Fig. 11 is a block diagram showing the electrical connections of component mounting system 110 using mounting head 122 of the alternative embodiment.

As shown in Fig. 10, mounting head 122 of the alternative embodiment includes head main body 122a, suction nozzle 24, rotating device 133, and lifting and lowering device 160. One or more nozzle holders 173 are attached to mounting head 122, and suction nozzle 24 is detachably attached to the lower end of nozzle holder 173. Suction nozzle 24 is attached to nozzle holder 173 so as to be movable in the vertical direction (i.e., the Z-axis direction). A compression coil spring (not shown) is built in nozzle holder 173, and suction nozzle 24 is biased upward with respect to nozzle holder 173 by the force of the compression coil spring. Rotation device 133 includes rotation motor 133a in which gear 133b is provided on a rotation shaft. Gear 176, which meshes with gear 133, is disposed at the upper end of nozzle holder 173 with respect to gear 133 in a manner such that nozzle holder 173 moves in the Z-axis direction. Mounting head 122 can adjust nozzle holder 173 to any angle by driving rotation motor 133a. Since suction nozzle 24 is attached to nozzle holder 173, mounting head 122 can adjust the angle of die D picked up with suction nozzle 24 by adjusting the angle of nozzle holder 173. Lifting and lowering device 160 includes first lifting and lowering device 161, second lifting and lowering device 165, and load cell 169. First lifting and lowering device 161 includes first linear motor 162, first Z-axis slider 163, which can be lifted and lowered in the Z-axis direction by driving of first linear motor 162, and first Z-axis position sensor 164, which detects the position of first Z-axis slider 163 in the Z-axis direction. First Z-axis slider 163 is formed with first engaging section 163a that can be engaged with horizontal section 174 provided on nozzle holder 173. As a result, suction nozzle 24 attached to nozzle holder 173 can be moved up and down in accordance with the movement of first Z-axis slider 163. Second lifting and lowering device 165 includes second linear motor 166 attached to first Z-axis slider 163 of first lifting and lowering device 161, and second Z-axis slider 167 which can be lifted and lowered in the Z-axis direction by driving of second linear motor 166. Second Z-axis slider 167 is formed with second engaging section 167a which engages with the upper face of flange section 172 extending in the radial direction in the upper section of suction nozzle 24. As a result, suction nozzle 24 can be moved up and down in accordance with the movement of second Z-axis slider 167. In the present embodiment, the stroke distance of second Z-axis slider 167 by second lifting and lowering device 165 is shorter than the stroke distance of first Z-axis slider 163 by first lifting and lowering device 161. After coarsely adjusting the Z-axis position of suction nozzle 24 with first lifting and lowering device 161, lifting and lowering device 160 finely adjusts the Z-axis position of suction nozzle 24 with second lifting and lowering device 165. Second Z-axis slider 167 is provided with load cell 169 for detecting load F acting on suction nozzle 24 when suction nozzle 24 picks up die D by suction.

Die peeling device 150 includes one lifting and lowering device 131 for lifting and lowering push-up pin 71, and Z-axis position sensor 132 for detecting the Z-axis position of push-up pin 71. Lifting and lowering device 131 includes a linear motor and a slider movable in the Z-axis direction by the linear motor, and push-up pin 71 can be lifted and lowered by moving the slider in the Z-axis direction.

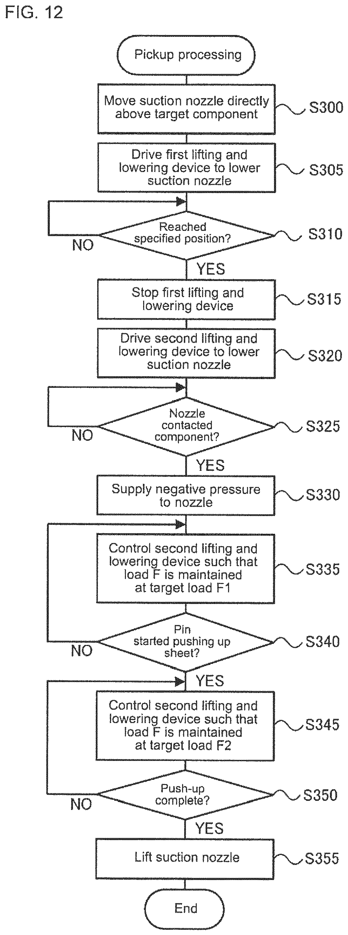

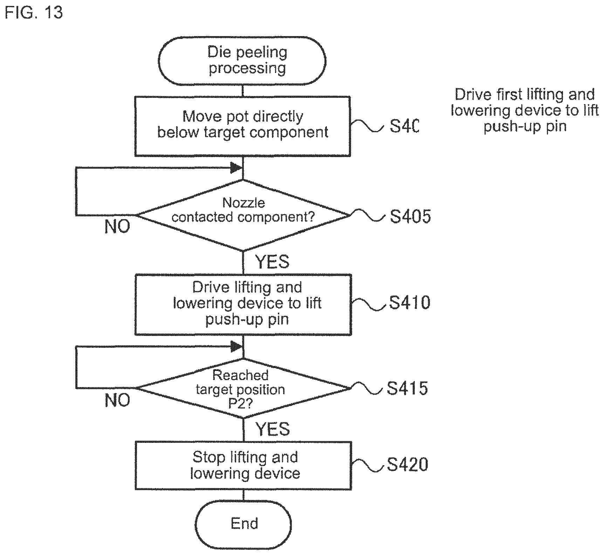

Next, the operation of component mounting system 110 of the alternative embodiment configured as described above will be described. Fig. 12 is a flowchart showing pickup processing of the alternative embodiment, and Fig. 13 is a flowchart showing die peeling processing of the alternative embodiment.

In the pickup processing, first, control device 29 of the component mounting apparatus 20 drives and controls head moving device 23 so that suction nozzle 24 moves to a location directly above the target die to be picked up (step S300). Next, control device 29 drives and controls first lifting and lowering device 161 so that suction nozzle 24 is lowered at a high speed (step S305). Control device 29 determines whether the position of suction nozzle 24 in the Z-axis direction, which is specified based on signals from first Z-axis position sensor 164 and second Z-axis position sensor 168, has reached a specified position (step S310). Here, the specified position is defined as a position a predetermined distance before the position at which suction nozzle 24 contacts die D. When it is determined that the position of suction nozzle 24 has not reached the specified position, control device 29 continues to lower suction nozzle 24 with first lifting and lowering device 161, and when it is determined that the position of suction nozzle 24 has reached the specified position, the driving of first lifting and lowering device 161 is stopped (step S315), and second lifting and lowering device 165 is driven and controlled so that suction nozzle 24 is further lowered but at a low speed (step S320). Control device 29 determines whether suction nozzle 24 has come into contact with the target die (step S325). This process can be performed, for example, by determining whether load F acting on suction nozzle 24 detected by load cell 169 exceeds a threshold value. When control device 29 determines that suction nozzle 24 is not in contact with the target die, control device 29 continues to lower suction nozzle 24, and when control device 29 determines that suction nozzle 24 has come into contact with the target die, control device 29 drives switch valve 36 to supply negative pressure to the suction port of suction nozzle 24 (step S330), and drives second lifting and lowering device 165 by feedback control so that load F acting on suction nozzle 24 is maintained at target load F1 (step S335). Target load F1 is a load for maintaining a state in which suction nozzle 24 is in contact with the target die and is set within a range in which excessive stress does not act on the target die. Next, control device 29 determines whether push-up pin 71 has started to push up the target die (step S340). This process can be performed, for example, by determining whether load F acting on suction nozzle 24 exceeds a threshold value. When control device 29 determines that push-up pin 71 has not started pushing the target die, control device 29 returns to step S340 to continue feedback control of second lifting and lowering device 165 using target load F1, and, when it is determined that push-up pin 71 has started pushing up the target die, control device 29 drives and controls second lifting and lowering device 165 by feedback control so that the load acting on suction nozzle 24 is maintained at target load F2 (step S345). Here, target load F2 can define a load equivalent to target load F* described above. Control device 29 may decrease target load F2, in the same way as target load F*, as the push-up amount of push-up pin 71 increases. Control device 29 determines whether pushing up of push-up pin 71 has been completed (step S350). This can be determined based on the determination result of step S415 of the die peeling processing of Fig. 13 (i.e., whether push-up pin 71 has reached target position P2). When it is determined that pushing up of push pin 71 has not been completed, control device 29 returns to step S345 to continue feedback control of second lifting and lowering device 165 using target load F2, and when it is determined that pushing up of push-up pin 71 has been completed, first lifting and lowering device 161 and second lifting and lowering device 165 are driven and controlled so that suction nozzle 24 is lifted (step S355), then ends the pickup processing. As a result, the target die is picked up by suction nozzle 24.

On the other hand, in the die peeling processing, control device 29 first drives and controls pot moving device 52 so that pot 51 is moved to a location directly under the target die (step S400). Next, control device 29 waits until suction nozzle 24 comes in contact with the target die (step S405). This can be performed based on the determination result in step S325 of the pickup process. When it is determined that suction nozzle 24 has come in contact with the target die, the control device 29 drives and controls lifting and lowering device 131 so that push-up pin 71 is lifted (step S410) and determines whether the position of the push-up pin 71 in the Z-axis direction has reached target position P2 based on a signal from Z-axis position sensor 132 (step S415). Here, target position P2 is the position of push-up pin 71 corresponding to the pickup position of suction nozzle 24. When it is determined that the position of push-up pin 71 has not reached the target position, control device 29 continues lifting push-up pin 71 by way of lifting and lowering device 131, and when it is determined that the position of push-up pin 71 has reached target position P2, driving of lifting and lowering device 131 is stopped (step S420), then ends the die peeling processing.

As described above, in component mounting apparatus 20 of the alternative embodiment, mounting head 122 includes first lifting and lowering device 161, second lifting and lowering device 165, and load cell 169. As a result, in component mounting apparatus 20, for example, before suction nozzle 24 comes into contact with the target die, suction nozzle 24 can be lowered at a high speed by first lifting and lowering device 161, and thereafter, suction nozzle 24 can be lowered at a low speed by second lifting and lowering device 165, and the impact when suction nozzle 24 comes into contact with the target die can be mitigated. Further, after the target die comes into contact with suction nozzle 24, component mounting apparatus 20 drives and controls second lifting and lowering device 165 by feedback control so that load F acting on suction nozzle 24 is maintained at target load F1. As a result, suction nozzle 24 can be pressed against the target die with an appropriate load, and the state in which suction nozzle 24 is in contact with the target die can be maintained. Further, when the target die is pushed up by push-up pin 71, component mounting apparatus 20 drives and controls second lifting and lowering device 165 by feedback control so that load F acting on suction nozzle 24 is maintained at target load F2. Thus, excessive stress is prevented from acting on the target die by the pushing up of push-up pin 71, and damage to the target die is effectively suppressed.

Here, in the alternative embodiment described above, first lifting device 161 corresponds to a "first nozzle lifting device", second lifting device 165 corresponds to a "second nozzle lifting and lowering device", lifting device 131 corresponds to a "push-up section lifting and lowering device", and load cell 169 corresponds to a "load measurement section".

In the alternative embodiment described above, mounting head 122 is provided with load cell 169 for measuring load F acting on suction nozzle 24, but the load acting on suction nozzle 24 may be measured by detecting or estimating the load current of second linear motor 166.

It should be noted that the present invention is not limited in any way to the above-mentioned embodiments, and it is needless to say that the present invention can be implemented in various modes as long as they fall within the technical scope of the present invention as defined by the appended claims.

### Industrial Applicability

The present invention can be applied in a manufacturing industry for wafer supply apparatuses and component mounting systems.

### Reference Signs List

10,110 component mounting system, 20 component mounting apparatus, 21 board conveyance device, 22,122 mounting head, 23 head moving device, 24 suction nozzle, 25 component camera, 26 mark camera, 28 tape supply device, 31,131 lifting and lowering device, 32 Z-axis position sensor, 33,133 rotation device, 40 wafer supply apparatus, 41 wafer pallet, 42 magazine, 43 die sheet, 44 pallet drawing device, 50 die peeling device, 51 pot, 52 pot moving device, 60,160 lifting and lowering device, 61,161 first lifting and lowering device, 62,162 first linear motor, 63,163 first Z-axis slider, 63a ,163a first engaging section, 64,164 first Z-axis position sensor, 65,165 second lifting and lowering device, 66,166 second linear motor, 67,167 second Z-axis slider, 67a, 167a second engaging section, 68,168 second Z-axis position sensor, 69,169 load cell, 71 push-up pin, 72 flange section, 73 pin support, 74 horizontal section, 80 management computer (PC), 122a head main body, 133a rotation motor, 133b gear, 172 flange section, 173 nozzle holder, 174 horizontal section, 176 gear, D die, S board, W wafer.

## Claims

1. A component mounting apparatus (20) for mounting a component on a target object by picking up the component with a nozzle (24) from a sheet (43) on which a wafer (W), being divided into multiple components, is adhered, comprising:
a head (22, 122);
a nozzle (24);
a first nozzle lifting and lowering device (161) of the head (22, 122) configured to lift and lower a lifting and lowering member (173) with respect to the head (22, 122);
a second nozzle lifting and lowering device (165) of the head configured to lift and lower the nozzle (24) with respect to the lifting and lowering member (173) and lifting and lowering the nozzle (24) with respect to the lifting and lowering member (173);
a peeling device (50);
a push-up section (71) configured to push up, from the back side of the sheet (43), a component to be picked up by the nozzle (24);
a push-up section lifting and lowering device (61, 65, 131) of the peeling device (50) configured to lift and lower the push-up section (71);
a load measuring section (69) configured to measure the load amount acting on the nozzle (24); and
a control section (29) configured to control the first nozzle lifting and lowering device (161) and the push-up section lifting and lowering device (61, 65, 131) so that the nozzle (24) is lowered to a predetermined nozzle position and the push-up section (71) is pushed up to a predetermined push-up position, and to control the second nozzle lifting and lowering device (165) so that the load amount measured by the load measuring section is maintained within a predetermined push-up load range while the nozzle (24) is in contact with the component and the component is being pushed up by the push-up section (71).

2. The component mounting apparatus (20) according to claim 1, wherein
the control section (29) is configured to control the first nozzle lifting and lowering device (161) so that the nozzle (24) is lowered to the predetermined nozzle position, to control the second nozzle lifting and lowering device (165) so that the nozzle (24) comes into contact with the component and the load amount measured by the load measuring section falls within a predetermined contact load range, to control the push-up section lifting and lowering device (131) so that the component is pushed up by the push-up section (71), and to control the second nozzle lifting and lowering device (165) so that the load amount measured by the load measuring section (69) is maintained within a predetermined push-up load range while the nozzle (24) is in contact with the component and the component is being pushed up by the push-up section (71).

## Patentansprüche

1. Komponentenmontagevorrichtung (20) zum Montieren einer Komponente auf einem Zielobjekt durch Aufnehmen der Komponente mit einer Düse (24) von einer Folie (43), auf der ein in mehrere Komponenten unterteilter Wafer (W), aufgeklebt ist, umfassend:
ein Kopf (22, 122);
eine Düse (24);
eine erste Düsenhub- und -absenkvorrichtung (161) des Kopfes (22, 122), die konfiguriert ist, um ein Hebe- und Senkelement (173) in Bezug zu dem Kopf (22, 122) anzuheben und abzusenken;
eine zweite Düsenhub- und -absenkvorrichtung (165) des Kopfes (22, 122), die konfiguriert ist, um die Düse (24) in Bezug auf das Hebe- und Senkelement (173) anzuheben und abzusenken und die Düse (24) in Bezug auf das Hebe- und Senkelement (173) anzuheben und abzusenken;
eine Abziehvorrichtung (50);
einen Anhebeabschnitt (71), der konfiguriert ist, um von der Rückseite des Blechs (43) eine von der Düse (24) aufzunehmende Komponente nach oben zu drücken;
eine Hebe- und Senkvorrichtung (61, 65, 131), die zum Heben und Senken des Anhebeabschnitts (71) der Abziehvorrichtung (50) konfiguriert ist;
einen Lastmessabschnitt (69), der konfiguriert ist, um die auf die Düse (24) wirkende Lastmenge zu messen; und
einen Steuerabschnitt (29), der konfiguriert ist, um die erste Düsenhub- und - absenkvorrichtung (161) und die Hebe- und Senkvorrichtung (61, 65, 131) des Anhebeabschnitts so zu steuern, dass die Düse (24) auf eine vorbestimmte Düsenposition abgesenkt wird und der Anhebeabschnitt (71) in eine vorbestimmte Anhebeposition gedrückt wird, und um die zweite Düsenhub- und -absenkvorrichtung (165) so zu steuern, dass die von dem Lastmessabschnitt gemessene Lastmenge innerhalb eines vorbestimmten Anhebe-Lastbereich gehalten wird, während die Düse (24) mit der Komponente in Kontakt steht und die Komponente vom Anhebeabschnitt (71) nach oben gedrückt wird.

2. Die Komponentenmontagevorrichtung (20) gemäß Anspruch 1, wobei
der Steuerabschnitt (29) konfiguriert ist, um die erste Düsenhub- und -absenkvorrichtung (161) so zu steuern, dass die Düse (24) in die vorbestimmte Düsenposition abgesenkt wird, um die zweite Düsenhub- und -absenkvorrichtung (165) so zu steuern, dass die Düse (24) mit der Komponente in Kontakt kommt und die vom Lastmessabschnitt gemessene Lastmenge in einen vorbestimmten Kontaktlastbereich fällt, um die Hebe- und Senkvorrichtung (131) des Anhebeabschnitts so zu steuern, dass die Komponente durch den Anhebeabschnitt (71) hoch gedrückt wird und die zweite Düsenhub- und -absenkvorrichtung (165) so zu steuern, dass die vom Lastmessabschnitt (69) gemessene Lastmenge in einem vorbestimmten Anhebe-Lastbereich gehalten wird, während die Düse (24) mit der Komponente in Kontakt steht und die Komponente vom Anhebeabschnitt (71) nach oben gedrückt wird.

## Revendications

1. Appareil de montage de composant (20) pour monter un composant sur un objet cible en saisissant le composant avec une buse (24) à partir d'une feuille (43) sur laquelle une tranche (W), qui est divisée en plusieurs composants, est collée, comprenant :
une tête (22, 122) ;
une buse (24) ;
un premier dispositif de levage et d'abaissement de buse (161) de la tête (22, 122) configuré pour lever et abaisser un élément de levage et d'abaissement (173) par rapport à la tête (22, 122) ;
un deuxième dispositif de levage et d'abaissement de buse (165) de la tête configuré pour lever et abaisser la buse (24) par rapport à l'élément de levage et d'abaissement (173) et levant et abaissant la buse (24) par rapport à l'élément de levage et d'abaissement (173) ;
un dispositif de décollement (50) ;
une section de poussée vers le haut (71) configurée pour pousser vers le haut, depuis le côté arrière de la feuille (43), un composant à saisir par la buse (24) ;
un dispositif de levage et d'abaissement de section de poussée vers le haut (61, 65, 131) du dispositif de décollement (50) configuré pour lever et abaisser la section de poussée vers le haut (71) ;
une section de mesure de charge (69) configurée pour mesurer la quantité de charge agissant sur la buse (24) ; et
une section de commande (29) configurée pour commander le premier dispositif de levage et d'abaissement de buse (161) et le dispositif de levage et d'abaissement de section de poussée vers le haut (61, 65, 131) de sorte que la buse (24) soit abaissée jusqu'à une position de buse prédéterminée et la section de poussée vers le haut (71) soit poussée vers le haut jusqu'à une position de poussée vers le haut prédéterminée, et pour commander le deuxième dispositif de levage et d'abaissement de buse (165) de sorte que la quantité de charge mesurée par la section de mesure de charge soit maintenue dans une plage de charge de poussée vers le haut prédéterminée tandis que la buse (24) est en contact avec le composant et que le composant est en train d'être poussé vers le haut par la section de poussée vers le haut (71).

2. Appareil de montage de composant (20) selon la revendication 1, dans lequel
la section de commande (29) est configurée pour commander le premier dispositif de levage et d'abaissement de buse (161) de sorte que la buse (24) soit abaissée jusqu'à la position de buse prédéterminée, pour commander le deuxième dispositif de levage et d'abaissement de buse (165) de sorte que la buse (24) entre en contact avec le composant et que la quantité de charge mesurée par la section de mesure de charge se situe dans une plage de charge de contact prédéterminée, pour commander le dispositif de levage et d'abaissement de section de poussée vers le haut (131) de sorte que le composant soit poussé vers le haut par la section de poussée vers le haut (71), et pour commander le deuxième dispositif de levage et d'abaissement de buse (165) de sorte que la quantité de charge mesurée par la section de mesure de charge (69) soit maintenue dans une plage de charge de poussée vers le haut prédéterminée tandis que la buse (24) est en contact avec le composant et que le composant est en train d'être poussé vers le haut par la section de poussée vers le haut (71).
